(19) **Europäisches Patentamt European Patent Office Office européen des brevets**

(11) **EP 4 730 975 A1**

(12) **EUROPEAN PATENT APPLICATION**
published in accordance with Art. 153(4) EPC

(43) Date of publication:
**22.04.2026  Bulletin 2026/17**

(21) Application number: **24823728.1**

(22) Date of filing: **13.06.2024**

(51) International Patent Classification (IPC):
**H10K 59/80** (2023.01)      **H10K 59/122** (2023.01)
**B60K 35/00** (2024.01)      **B60K 35/60** (2024.01)
**B60K 35/22** (2024.01)      **B60K 35/40** (2024.01)
**H10K 102/00** (2023.01)

(52) Cooperative Patent Classification (CPC):
**H10K 59/126; B60K 35/22; H10K 59/122;**
**H10K 59/127; H10K 59/8722; H10K 59/8792;**
B60K 2360/1523; H10K 2102/351

(86) International application number:
**PCT/KR2024/008134**

(87) International publication number:
**WO 2024/258211 (19.12.2024 Gazette 2024/51)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **14.06.2023  KR 20230076443**

(71) Applicant: **Samsung Display Co., Ltd.**
**Yongin-si, Gyeonggi-do 17113 (KR)**

(72) Inventors:
• **KIM, Dae Won**
**Yongin-si Gyeonggi-do 17113 (KR)**

• **SON, Jong Ho**
**Yongin-si Gyeonggi-do 17113 (KR)**
• **SHIN, Hye Beom**
**Yongin-si Gyeonggi-do 17113 (KR)**
• **LEE, Kyung Hee**
**Yongin-si Gyeonggi-do 17113 (KR)**
• **CHANG, Sun Young**
**Yongin-si Gyeonggi-do 17113 (KR)**

(74) Representative: **Dr. Weitzel & Partner**
**Patent- und Rechtsanwälte mbB**
**Friedenstrasse 10**
**89522 Heidenheim (DE)**

(54) **DISPLAY DEVICE AND VEHICLE INCLUDING SAME**

(57)     A display device includes a first substrate, a pixel electrode disposed on the first substrate, a pixel defining layer disposed on the first substrate and covering at least a portion of the pixel electrode, a second substrate disposed on the pixel defining layer and spaced apart from the first substrate and the pixel defining layer to define a space between the second substrate and the pixel defining layer, and a light blocking pattern disposed on a surface of the second substrate facing the first substrate and overlapping the pixel defining layer in a plan view.

[FIG. 3]

## Description

[Technical Field]

The present invention relates to a display device. More specifically, the present invention relates to a display device that provides visual information and a vehicle including the display device.

[Background Art]

If impurities such as moisture, oxygen, or the like enter a display device from outside, a lifespan of a transistor included in the display device may be shortened and a luminous efficiency of a light emitting element included in the display device may decrease.

Accordingly, the display device may be encapsulated to prevent the impurities from penetrating by isolating inside of the display device from the outside. For example, the display device may include a substrate and an encapsulation substrate that forms a cover or a cap on the substrate. The substrate and the encapsulation substrate may be integrally coupled by a sealing member.

[Disclosure]

[Technical Purpose]

An object of the present invention is to provide a display device with improved display quality.

Another object of the present invention is to provide a vehicle including the display device.

However, the object of the present invention is not limited by the above-described objects, and may be variously expanded without departing from the idea and scope of the present invention.

[Technical Solution]

In order to achieve the object of the present invention described above, a display device according to an embodiment of the present invention may include a first substrate, a pixel electrode disposed on the first substrate, a pixel defining layer disposed on the first substrate and covering at least a portion of the pixel electrode, a second substrate disposed on the pixel defining layer and spaced apart from the first substrate and the pixel defining layer to define a space between the second substrate and the pixel defining layer, and a light blocking pattern disposed on a surface of the second substrate facing the first substrate and overlapping the pixel defining layer in a plan view.

In an embodiment, a distance between an edge of a surface of the pixel defining layer facing the second substrate and an edge of a surface of the light blocking pattern facing the second substrate may satisfy following Equation 1:

$$X = D \times \tan\left[\sin^{-1}\left\{\frac{n2}{n1} \times \sin\left(\sin^{-1}\left(\frac{n3}{n2} \times \sin \Theta\right)\right)\right\}\right] \pm 1$$ micrometers ($\mu$m). In Equation 1, "X" may be the distance between the edge of the surface of the pixel defining layer and the edge of the surface of the light blocking pattern, "D" may be a distance between the surface of the pixel defining layer and the surface of the second substrate, "n1" may be a refractive index of the space, "n2" may be a refractive index of the second substrate, "n3" may be a refractive index of air, and "$\theta$" may be a viewing angle.

In an embodiment, a width of the surface of the light blocking pattern may satisfy following Equation 2: W=G-2X. In Equation 2, "W" may be the width of the surface of the light blocking pattern, and "G" may be a width of the surface of the pixel defining layer.

In an embodiment, the display device may further include a spacer disposed between the pixel defining layer and the light blocking pattern.

In an embodiment, a sum of a thickness of the light blocking pattern and a thickness of the spacer may be greater than about 3 micrometers ($\mu$m) and less than or equal to about 20 $\mu$m.

In an embodiment, the light blocking pattern may be provided in plurality, and the spacer may overlap at least one of the plurality of light blocking pattern in a plan view.

In an embodiment, a maximum width of the light blocking pattern may be greater than a width of the spacer.

In an embodiment, the display device may further include a light emitting layer disposed on the pixel electrode, a common electrode disposed on the light emitting layer, the pixel defining layer, and the spacer, and a capping layer disposed on the common electrode.

In an embodiment, the light blocking pattern may include a black matrix.

In an embodiment, the display device may further include a sealing member disposed between the first substrate and the second substrate along an edge of each of the first substrate and the second substrate and coupling the first substrate and the second substrate.

In an embodiment, the second substrate may include a glass substrate.

In an embodiment, the space may be an empty space.

In an embodiment, the space may be filled with a filler.

In order to achieve the another object of the present invention described above, a vehicle according to an embodiment of the present invention may include a vehicle body defining an interior space, and a display device disposed in the interior space. The display device may include a first substrate, a pixel electrode disposed on the first substrate, a pixel defining layer disposed on the first substrate and covering at least a portion of the pixel electrode, a spacer disposed on the pixel defining layer, a second substrate disposed on the spacer and spaced apart from the first substrate and the spacer to define a space between the second substrate and pixel defining layer, a transmission pattern disposed on a surface of the second substrate facing the first substrate and overlapping the pixel defining layer in a plan view, and a light blocking pattern disposed on the transmission pattern and defining an opening, which accommodates at least a portion of the spacer.

In an embodiment, the light blocking pattern may cover at least a portion of a side surface of the spacer.

In an embodiment, the light blocking pattern may be provided in plurality, and the spacer may be accommodated in the opening of at least one of the plurality of light blocking patterns.

In an embodiment, the transmission pattern may include a transparent organic material.

In an embodiment, the light blocking pattern may include a black matrix.

In an embodiment, the display device may further include a sealing member disposed between the first substrate and the second substrate along an edge of each of the first substrate and the second substrate and coupling the first substrate and the second substrate.

In an embodiment, the second substrate may include a glass substrate.

In an embodiment, the space may be an empty space.

In an embodiment, the space may be filled with a filler.

In an embodiment, the vehicle may further include a cluster, a center fascia adjacent to the cluster, and a passenger seat dashboard adjacent to the center fascia. The display device may be disposed on at least one of the cluster, the center fascia, and the passenger seat dashboard.

[Advantageous Effects]

In a display device according to embodiments of the present invention, a light blocking pattern overlapping a pixel defining layer in a plan view may be disposed between a first substrate and a second substrate. The light blocking pattern may block incident light incident from outside and reflection light in which the incident light is reflected by the pixel defining layer. In addition, a thickness of a space between the first substrate and the second substrate may increase. Accordingly, coherence may be reduced, and a rainbow-colored color shift phenomenon visibly recognized at a side viewing angle may be effectively improved.

However, effects of the present invention are not limited to the above-described effects, and may be variously expanded without departing from the idea and scope of the present invention.

[Description of Drawings]

FIG. 1 is a plan view illustrating a display device according to an embodiment of the present invention.

FIG. 2 is a cross-sectional view taken along line I-I' of FIG. 1.

FIG. 3 is an enlarged cross-sectional view of area A of FIG. 2.

FIG. 4 is an enlarged cross-sectional view of area B of FIG. 3.

FIG. 5 is a cross-sectional view illustrating another example of FIG. 3.

FIG. 6 is a plan view illustrating a display device according to another embodiment of the present invention.

FIG. 7 is a cross-sectional view taken along line II-II' of FIG. 6.

FIG. 8 is a cross-sectional view illustrating another example of FIG. 7.

FIG. 9 is a cross-sectional view illustrating a display device according to still another embodiment of the present invention.

FIG. 10 is a cross-sectional view illustrating another example of FIG. 9.

FIG. 11 is a view schematically illustrating an exterior of a vehicle according to an embodiment of the present invention.

FIG. 12 is a view schematically illustrating an interior space of the vehicle of FIG. 11.

[Best Mode]

[Mode for Invention]

Hereinafter, embodiments of the present invention will be described in more detail with reference to the accompanying drawings. The same reference numerals are used for the same components in the drawings, and redundant descriptions of the same components will be omitted.

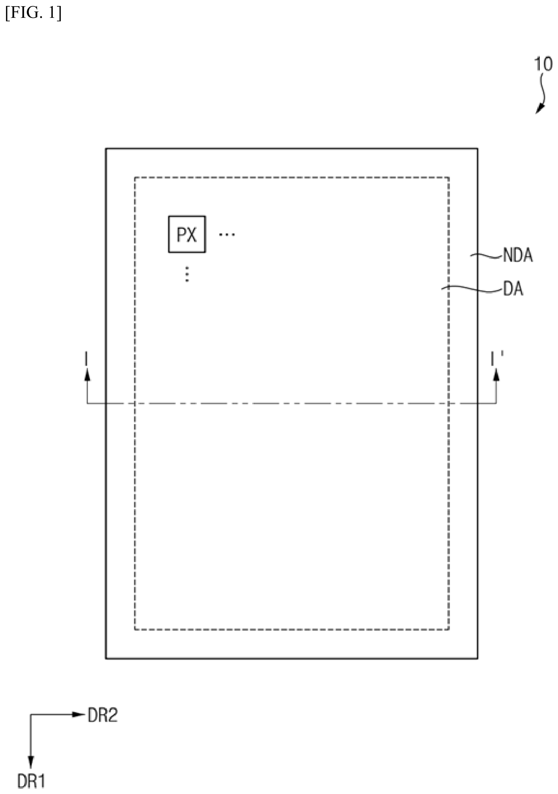

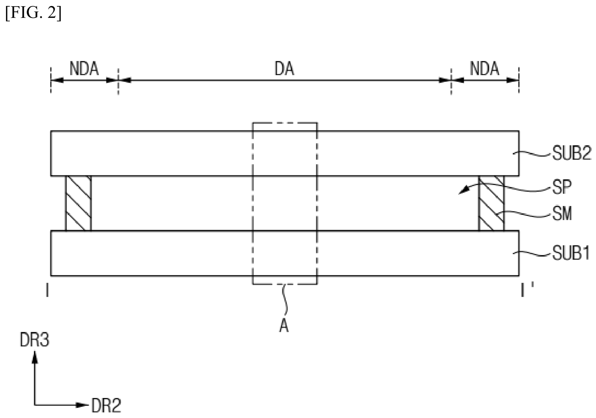

FIG. 1 is a plan view illustrating a display device according to an embodiment of the present invention. As used herein, the "plan view" is a view in a thickness direction (i.e., third direction DR3) of a first substrate (See SUB1 in FIG. 2).

Referring to FIG. 1, a display device 10 may include a display area DA and a non-display area NDA. The display area DA may be an area that displays an image by generating light or adjusting a transmittance of light provided from an external light source. The non-display area NDA may be an area that does not display an image. The non-display area NDA may be located around the display area DA. In an embodiment, for example, the non-display area NDA may surround the entirety of the display area DA.

A plurality of pixels PX may be disposed in the display area DA. The plurality of pixels PX may be arranged in a matrix form along a first direction DR1 and a second direction DR2 intersecting the first direction DR1. In an embodiment, for example, the first direction DR1 may be perpendicular to the second direction DR2. Each of the plurality of pixels PX may emit light. As each of the plurality of pixels PX emits light, the display area DA may display an image.

Lines connected to the plurality of pixels PX may be further disposed in the display area DA. In an embodiment, for example, the lines may include data signal lines, gate signal lines, power lines, or the like.

Drivers for driving the plurality of pixels PX may be disposed in the non-display area NDA. In an embodiment, for example, the drivers may include a data driver, a gate driver, a power voltage generator, timing controller, or the like. The plurality of pixels PX may emit light based on signals received from the drivers.

FIG. 2 is a cross-sectional view taken along line I-I' of FIG. 1.

Referring to FIGS. 1 and 2, the display device 10 may include a first substrate SUB1, a second substrate SUB2, and a sealing member SM.

The first substrate SUB1 may include a transparent material or an opaque material. In an embodiment, for example, the first substrate SUB1 may include a rigid glass substrate, a polymer substrate, a flexible film, a metal substrate, or the like. These may be used alone or in combination with each other. In an embodiment, the first substrate SUB1 may include a rigid glass substrate.

The second substrate SUB2 may be disposed on the first substrate SUB1. The second substrate SUB2 may face the first substrate SUB1. The second substrate SUB2 may be spaced apart from the first substrate SUB1 in a third direction DR3 intersecting each of the first direction DR1 and the second direction DR2. In an embodiment, for example, the third direction DR3 may be perpendicular to each of the first direction DR1 and the second direction DR2. Accordingly, a space SP between the first substrate SUB1 and the second substrate SUB2 may be defined. In an embodiment, the space SP may be an empty space (e.g., in a vacuum state). In another embodiment, the space SP may be filled with a filler.

The second substrate SUB2 may include a transparent material or an opaque material. In an embodiment, for example, the second substrate SUB2 may include a rigid glass substrate, a polymer substrate, a flexible film, a metal substrate, or the like. These may be used alone or in combination with each other. In an embodiment, the second substrate SUB2 may include a rigid glass substrate.

The sealing member SM may be disposed between the first substrate SUB1 and the second substrate SUB2, and may be disposed along an edge of each of the first substrate SUB1 and the second substrate SUB2. That is, the sealing member SM may be disposed along the non-display area NDA between the first substrate SUB1 and the second substrate SUB2. The first substrate SUB1 and the second substrate SUB2 may be coupled to each other by the sealing member SM. As the space SP between the first substrate SUB1 and the second substrate SUB2 is sealed by the sealing member SM, external moisture, air, impurities, or the like may be prevented from penetrating into the space SP. In an embodiment, for example, the sealing member SM may include an organic material such as epoxy resin.

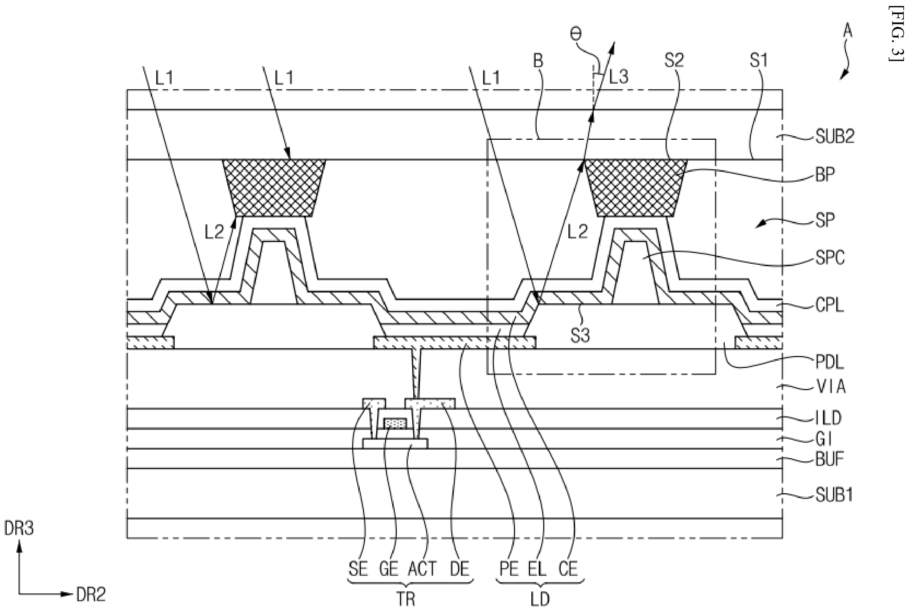

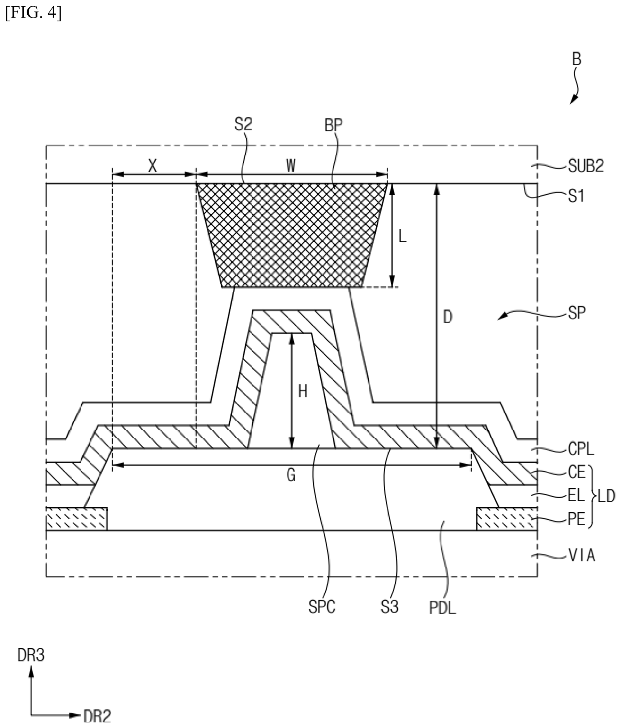

FIG. 3 is an enlarged cross-sectional view of area A of FIG. 2. FIG. 4 is an enlarged cross-sectional view of area B of FIG. 3.

Referring to FIGS. 3 and 4, the display device 10 may include the first substrate SUB1, a buffer layer BUF, a transistor TR, a gate insulating layer GI, an interlayer-insulating layer ILD, a via-insulating layer VIA, a pixel defining layer PDL, a light emitting element LD, a spacer SPC, a capping layer CPL, a light blocking pattern BP, and the second substrate SUB2.

The transistor TR may include an active pattern ACT, a gate electrode GE, a source electrode SE, and a drain electrode DE. The light emitting element LD may include a pixel electrode PE, a light emitting layer EL, and a common electrode CE.

The buffer layer BUF may be disposed on the first substrate SUB1. The buffer layer BUF may prevent metal atoms or impurities from diffusing from the first substrate SUB1 to the transistor TR. In addition, the buffer layer BUF may improve a flatness of a surface of the first substrate SUB1 when the surface of the first substrate SUB1 is not uniform. The buffer layer BUF may include an inorganic material such as silicon oxide ($SiO_x$), silicon nitride ($SiN_x$), silicon oxynitride ($SiO_xN_y$), or the like. These may be used alone or in combination with each other.

The active pattern ACT may be disposed on the buffer layer BUF. The active pattern ACT may include a source area, a drain area, and a channel area located between the source area and the drain area. The active pattern ACT may include a silicon semiconductor material or an oxide semiconductor material. Examples of the silicon semiconductor material may include amorphous silicon, polycrystalline silicon, or the like. Examples of the oxide semiconductor material may include indium gallium zinc oxide ("IGZO"), indium tin zinc oxide ("ITZO"), or the like. These may be used alone or in combination with each other.

The gate insulating layer GI may be disposed on the buffer layer BUF. The gate insulating layer GI may sufficiently cover the active pattern ACT, and may have a substantially flat upper surface without creating a step around the active pattern ACT. Alternatively, the gate insulating layer GI may cover the active pattern ACT, and may be disposed along a profile of the active pattern ACT with a uniform thickness. The gate insulating layer GI may include an inorganic material such as silicon oxide ($SiO_x$), silicon nitride ($SiN_x$), silicon carbide ($SiC_x$), silicon oxynitride ($SiO_xN_y$), silicon oxycarbide ($SiO_xC_y$), or the like. These may be used alone or in combination with each other.

The gate electrode GE may be disposed on the gate insulating layer GI. The gate electrode GE may overlap the channel area of the active pattern ACT in a plan view. The gate electrode GE may include metal, alloy, conductive metal oxide, metal nitride, or the like. Examples of the metal may include silver (Ag), molybdenum (Mo), aluminum (Al), tungsten (W), copper (Cu), nickel (Ni), chromium (Cr), titanium (Ti), tantalum (Ta), platinum (Pt), scandium (Sc), or the like. Examples of the conductive metal oxide may include indium tin oxide, indium zinc oxide, or the like. Examples of the metal nitride may include aluminum nitride ($AlN_x$), tungsten nitride ($WN_x$), chromium nitride ($CrN_x$), or the like. These may be used alone or in combination with each other.

The interlayer-insulating layer ILD may be disposed on the gate insulating layer GI. The interlayer-insulating layer ILD may sufficiently cover the gate electrode GE, and may have a substantially flat upper surface without creating a step around the gate electrode GE. Alternatively, the interlayer-insulating layer ILD may cover the gate electrode GE, and may be disposed along a profile of the gate electrode GE with a uniform thickness. The interlayer-insulating layer ILD may include an inorganic material such as silicon oxide, silicon nitride, silicon carbide, silicon oxynitride, silicon oxycarbide, or the like. These may be used alone or in combination with each other.

The source electrode SE and the drain electrode DE may be disposed on the interlayer-insulating layer ILD. The source electrode SE may be connected to the source area of the active pattern ACT through a first contact hole penetrating a first portion of the gate insulating layer GI and the interlayer-insulating layer ILD. In addition, the drain electrode DE may be connected to the drain area of the active pattern ACT through a second contact hole penetrating a second portion of the gate insulating layer GI and the interlayer-insulating layer ILD. In an embodiment, for example, each of the source electrode SE and the drain electrode DE may include a metal, alloy, metal nitride, conductive metal oxide, transparent conductive material, or the like. These may be used alone or in combination with each other.

Accordingly, the transistor TR including the active pattern ACT, the gate electrode GE, the source electrode SE, and the drain electrode DE may be disposed on the first substrate SUB1.

The via-insulating layer VIA may be disposed on the interlayer-insulating layer ILD. The via-insulating layer VIA may sufficiently cover the source electrode SE and the drain electrode DE. The via-insulating layer VIA may include an organic material such as phenol resin, acrylic resin, polyimide resin, polyamide resin, siloxane resin, epoxy resin, or the like. These may be used alone or in combination with each other.

The pixel electrode PE may be disposed on the via-insulating layer VIA. The pixel electrode PE may be connected to the drain electrode DE through a contact hole penetrating the via-insulating layer VIA. The pixel electrode PE may include metal, alloy, metal nitride, conductive metal oxide, transparent conductive material, or the like. These may be used alone or in combination with each other. For example, the pixel electrode PE may operate as an anode.

The pixel defining layer PDL may be disposed on the via-insulating layer VIA. The pixel defining layer PDL may cover at least a portion of the pixel electrode PE. In an embodiment, for example, the pixel defining layer PDL may cover an edge of the pixel electrode PE. That is, an opening exposing at least a portion of an upper surface of the pixel electrode PE may be defined in the pixel defining layer PDL. The pixel defining layer PDL may include an inorganic material or an organic material. In an embodiment, for example, the pixel defining layer PDL may include an organic material such as epoxy resin, siloxane resin, or the like. These may be used alone or in combination with each other. For another example, the pixel defining layer PDL may include an inorganic material or an organic material including a black-colored light blocking material.

The spacer SPC may be disposed on the pixel defining layer PDL. Specifically, the spacer SPC may protrude from an upper surface of the pixel defining layer PDL in a thickness direction (e.g., the third direction DR3). The spacer SPC may prevent display characteristics from being deteriorated due to external impact. The spacer SPC may serve to maintain the space SP between the first substrate SUB1 and the second substrate SUB2. In addition, the spacer SPC may serve to support a fine metal mask ("FMM") used to deposit an organic light emitting material. The spacer SPC may include an inorganic material or an organic material.

In an embodiment, for example, the spacer SPC may be formed simultaneously with the pixel defining layer PDL through the same process. In this case, the spacer SPC may include the same material as the pixel defining layer PDL. For another example, the spacer SPC may be formed through a separate process from the pixel defining layer PDL. In this case, the spacer SPC may include a different material from the pixel defining layer PDL, or may include the same material as the pixel defining layer PDL.

The light emitting layer EL may be disposed on the pixel electrode PE. Specifically, the light emitting layer EL may be disposed in the opening in the pixel defining layer PDL. The light emitting layer EL may include an organic light emitting material that emits light of a preset color. In an embodiment, for example, the light emitting layer EL may include an organic light emitting material that emits red light, green light, or blue light.

The common electrode CE may be disposed on the light emitting layer EL, the pixel defining layer PDL, and the spacer SPC. The common electrode CE may be a plate electrode. The common electrode CE may include metal, alloy, metal nitride, conductive metal oxide, transparent conductive material, or the like. These may be used alone or in combination with each other. In an embodiment, for example, the common electrode CE may operate as a cathode.

Accordingly, the light emitting element LD including the pixel electrode PE, the light emitting layer EL, and the common electrode CE may be disposed on the first substrate SUB1. The light emitting element LD may be electrically connected to the transistor TR.

The capping layer CPL may be disposed on the common electrode CE. The capping layer CPL may protect the common electrode CE. The capping layer CPL may include an organic insulating material or an inorganic insulating material.

In an embodiment, the light blocking pattern BP may be disposed between the capping layer CPL and the second substrate SUB2. Specifically, the light blocking pattern BP may be disposed on a surface S1 of the second substrate SUB2 facing the first substrate SUB1. The light blocking pattern BP may contact each of the surface S1 of the second substrate SUB2 and the capping layer CPL. In addition, the light blocking pattern BP may overlap each of the pixel defining layer PDL and the spacer SPC in a plan view. The light blocking pattern BP may serve to maintain the space SP between the first substrate SUB1 and the second substrate SUB2 together with the spacer SPC.

The light blocking pattern BP may include a light blocking material. In an embodiment, for example, the light blocking pattern BP may include a black matrix. The light blocking pattern BP may absorb or block incident light L1 incident from outside through the second substrate SUB2. In addition, the light blocking pattern BP may absorb or block a reflected light L2 in which the incident light L1 is reflected by the pixel defining layer PDL.

When the light blocking pattern BP is not disposed between the pixel defining layer PDL and the second substrate SUB2, interference may occur between the reflected light L2 reflected and emitted by the pixel defining layer PDL and re-reflected light in which the reflected light L2 is re-reflected and emitted by the second substrate SUB2. In this case, a rainbow-colored color shift may be visually recognized at a side viewing angle $\theta$ due to the interference. The viewing angle $\theta$ at which the color shift is visually recognized by a user may be about 60° or less. Here, the "viewing angle" $\theta$ is defined as a maximum angle between the user's gaze direction and a normal vector of an upper surface of the second substrate SUB2 parallel to the third direction DR3, where the user's gaze direction is a direction in which the user can view an image outputted from the display device 10 with a predetermined acceptable level of quality. That is, when the display device 10 is viewed from a vertical direction, the viewing angle $\theta$ may be about 0°.

On the other hand, when the light blocking pattern BP is disposed between the pixel defining layer PDL and the second substrate SUB2, the light blocking pattern BP may absorb or block the incident light L1 and the reflected light L2, and coherence may be reduced. That is, the color shift at the side viewing angle $\theta$ due to the interference may be effectively reduced.

In this case, the light blocking pattern BP may be disposed so that the color shift does not occur at the viewing angle $\theta$ of about 60°. In other words, the light blocking pattern BP may be disposed so that the color shift may not occur when the viewing angle of a light L3 in which the reflected light L2 is refracted by the second substrate SUB2 and emitted to the outside is about 60°.

However, the present invention is not limited thereto, and the viewing angle θ considered in an arrangement of the light blocking pattern BP may be variously changed. Alternatively, when the display device 10 is used in a vehicle, the light blocking pattern BP may be disposed so that the color shift does not occur at the viewing angle θ of about 0° to about 10°.

In an embodiment, a distance X between an edge of a surface S2 of the light blocking pattern BP facing the second substrate SUB2 and an edge of a surface S3 of the pixel defining layer PDL facing the second substrate SUB2 may have a constant range. The distance X may satisfy Equation 1 below:

[Equation 1]

$$X = D \times \tan\left[\sin^{-1}\left\{\frac{n2}{n1} \times \sin\left(\sin^{-1}\left(\frac{n3}{n2} \times \sin\Theta\right)\right)\right\}\right] \pm 1 \text{ micrometers } (\mu m).$$

In Equation 1, "D" may be a distance between the surface S3 of the pixel defining layer PDL and the surface S1 of the second substrate SUB2, and "θ" may be the viewing angle. In addition, "n1" may be a refractive index of the space SP, "n2" may be a refractive index of the second substrate SUB2, and "n3" may be a refractive index of the outside.

In an embodiment, when the space SP is in a vacuum state, the refractive index n1 of the space SP may be a refractive index of vacuum (e.g., 1). In another embodiment, when the space SP is filled with the filler, the refractive index n1 of the space SP may be a refractive index of the filler.

In an embodiment, the refractive index n3 of the outside may be a refractive index of an outside air. That is, the refractive index n3 of the outside may be about 1.

In an embodiment, for example, the space SP may be in a vacuum state, and the refractive index n1 of the space SP may be about 1. The refractive index n2 of the second substrate SUB2 may be about 1.5, and the refractive index n3 of the outside may be about 1. The viewing angle θ may be about 60°, and the distance X may be about 4 micrometers (μm) to about 6 μm. However, the present invention is not limited thereto.

In addition, a width W of the surface S2 of the light blocking pattern BP may satisfy Equation 2 below. In this case, the width W of the light blocking pattern BP may be a length of the surface S2 of the light blocking pattern BP in the second direction DR2.

[Equation 2]

$$W = G - 2X.$$

In Equation 2, "G" may be a width of the surface S3 of the pixel defining layer PDL, and "X" may be the distance between the edge of the surface S2 of the light blocking pattern BP facing the second substrate SUB2 and the edge of the surface S3 of the pixel defining layer PDL facing the second substrate SUB2.

In this case, the width G of the pixel defining layer PDL may be a length of the surface S3 of the pixel defining layer PDL in the second direction DR2, and the width W of the surface S2 of the light blocking pattern BP may be a positive number.

In an embodiment, a maximum width (e.g., the width W of the surface S2) of the light blocking pattern BP in the second direction DR2 may be greater than a width of the spacer SPC. In this case, the width of the spacer SPC may be a length of the spacer SPC in the second direction DR2. However, the present invention is not limited thereto. Alternatively, the width W of the light blocking pattern BP may be less than or equal to the width of the spacer SPC in another embodiment.

In addition, a sum of a thickness L of the light blocking pattern BP and a thickness H of the spacer SPC may be greater than about 3 μm and less than or equal to about 20 μm. In this case, the thickness L of the light blocking pattern BP and the thickness H of the spacer SPC may be a length of the light blocking pattern BP and a length of the spacer SPC in the third direction DR3, respectively. In an embodiment, for example, the thickness L of the light blocking pattern BP may be about 1.2 μm to about 1.8 μm, but the present invention is not limited thereto.

Since the light blocking pattern BP is disposed between the spacer SPC and the second substrate SUB2, a length of the space SP in the third direction DR3 may be relatively thick, and the interference causing the color shift may be effectively reduced.

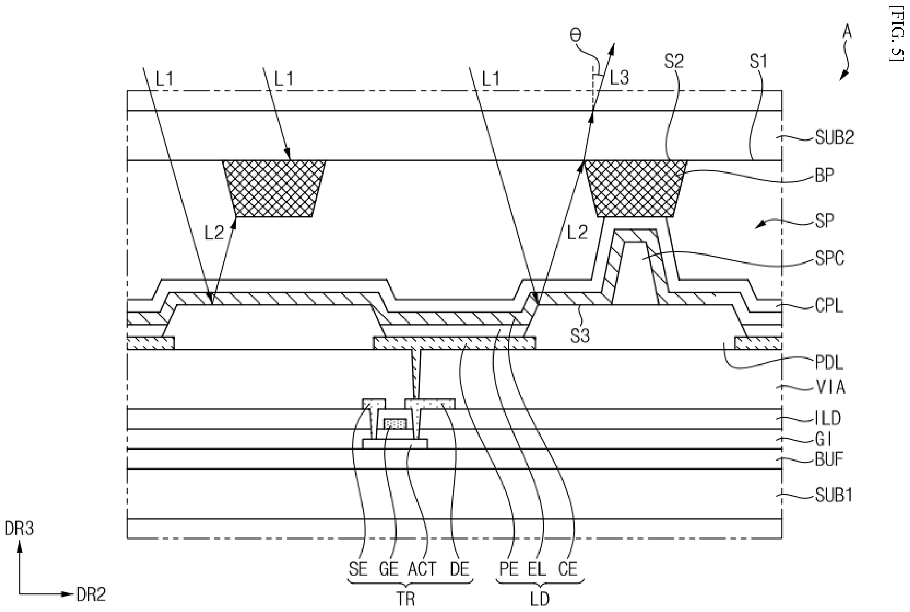

FIG. 5 is a cross-sectional view illustrating another example of FIG. 3.

Referring to FIGS. 3 and 5, the display device 10 may include the first substrate SUB1, the buffer layer BUF, the transistor TR, the gate insulating layer GI, the interlayer-insulating layer ILD, the via-insulating layer VIA, the pixel defining layer PDL, the light emitting element LD, the spacer SPC, the capping layer CPL, the light blocking pattern BP, and the second substrate SUB2.

However, the display device 10 described with reference to FIG. 5 may be substantially the same as or similar to the display device 10 described with reference to FIG. 3, except for the spacer SPC. Hereinafter, redundant descriptions will be omitted or simplified.

The buffer layer BUF, the active pattern ACT, the gate insulating layer GI, the gate electrode GE, the interlayer-insulating layer ILD, the source electrode SE, the drain electrode DE, the via-insulating layer VIA, the pixel electrode PE, the pixel defining layer PDL, and the light emitting layer EL may be sequentially disposed on the first substrate SUB1.

The spacer SPC may be disposed on the pixel defining layer PDL. In an embodiment, the spacer SPC may be disposed on some of the pixel defining layers PDL. That is, the spacer SPC may overlap some of the pixel defining layers PDL, and may not overlap others of the pixel defining layers PDL in a plan view.

The common electrode CE may be disposed on the light emitting layer EL, the pixel defining layer PDL, and the spacer SPC, and the capping layer CPL may be disposed on the common electrode CE.

The light blocking pattern BP may be disposed between the capping layer CPL and the second substrate SUB2. Specifically, the light blocking pattern BP may be disposed on the surface S1 of the second substrate SUB2 facing the first substrate SUB1.

In an embodiment, some of the light blocking patterns BP may overlap each of the pixel defining layer PDL and the spacer SPC in a plan view. Others of the light blocking patterns BP may overlap the pixel defining layer PDL, and may not overlap the spacer SPC. That is, the spacer SPC may overlap at least one of the light blocking patterns BP in a plan view.

In other words, some of the light blocking patterns BP may contact each of the surface S1 of the second substrate SUB2 and the capping layer CPL. Others of the light blocking patterns BP may contact the surface S1 of the second substrate SUB2, and may not contact the capping layer CPL.

In the display device 10 according to an embodiment of the present invention, the light blocking pattern BP overlapping the pixel defining layer PDL in a plan view may be disposed on the second substrate SUB2. The light blocking pattern BP may block the incident light L1 incident from the outside and the reflected light L2 in which the incident light L1 is reflected by the pixel defining layer PDL. In addition, the thickness of the space SP between the first substrate SUB1 and the second substrate SUB2 may increase. Accordingly, coherence may be reduced, and the rainbow-colored color shift phenomenon visually recognized at the side viewing angle may be effectively improved.

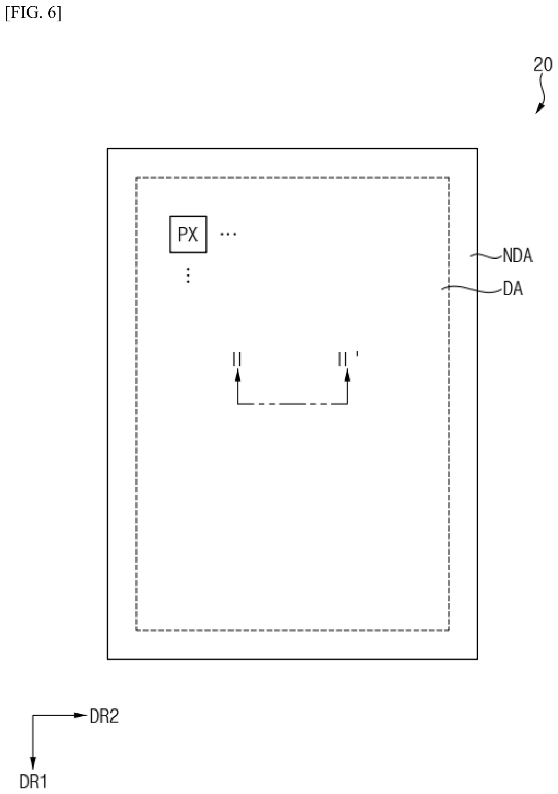

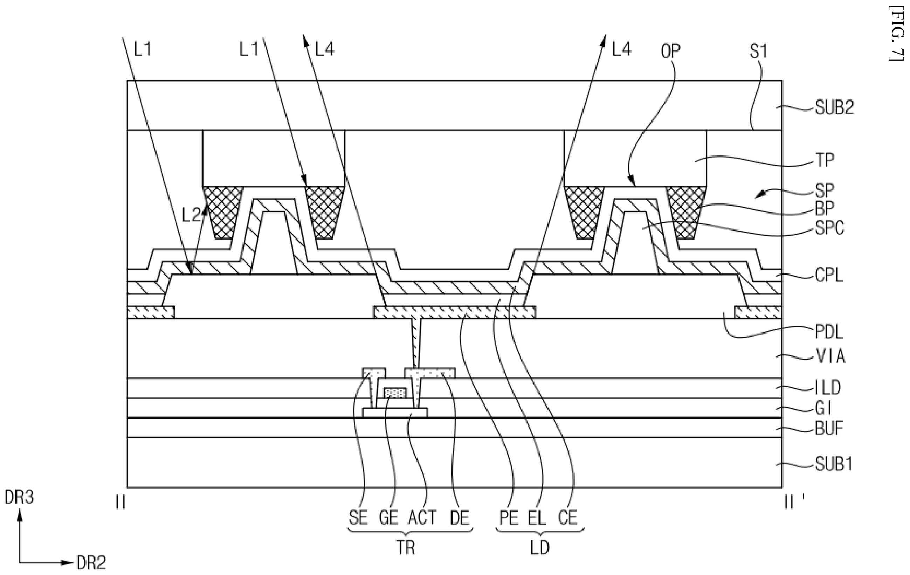

FIG. 6 is a plan view illustrating a display device according to another embodiment of the present invention. FIG. 7 is a cross-sectional view taken along line II-II' of FIG. 6.

Hereinafter, descriptions overlapping the display device 10 described with reference to FIGS. 1, 2, 3, 4 and 5 will be omitted or simplified.

Referring to FIG. 6, a display device 20 may include a display area DA and a non-display area NDA. The display area DA may be an area that displays an image, and the non-display area NDA may be an area that does not display an image. A plurality of pixels PX may be disposed in the display area DA, and drivers for driving the plurality of pixels PX may be disposed in the non-display area NDA.

Referring to FIGS. 6 and 7, the display device 20 may include a first substrate SUB1, a buffer layer BUF, a transistor TR, a gate insulating layer GI, an interlayer-insulating layer ILD, a via-insulating layer VIA, a pixel defining layer PDL, a light emitting element LD, a spacer SPC, a capping layer CPL, a transmission pattern TP, a light blocking pattern BP, and a second substrate SUB2.

The transistor TR may include an active pattern ACT, a gate electrode GE, a source electrode SE, and a drain electrode DE. The light emitting element LD may include a pixel electrode PE, a light emitting layer EL, and a common electrode CE.

The buffer layer BUF, the active pattern ACT, the gate insulating layer GI, the gate electrode GE, the interlayer-insulating layer ILD, the source electrode SE, the drain electrode DE, the via-insulating layer VIA, the pixel electrode PE, the pixel defining layer PDL, the spacer SPC, the light emitting layer EL, the common electrode CE, and the capping layer CPL may be sequentially disposed on the first substrate SUB1.

In an embodiment, the transmission pattern TP may be disposed between the capping layer CPL and the second substrate SUB2. Specifically, the transmission pattern TP may be disposed on a surface S1 of the second substrate SUB2 facing the first substrate SUB1. In an embodiment, for example, the transmission pattern TP may contact each of the surface S1 of the second substrate SUB2 and the capping layer CPL. In addition, the transmission pattern TP may overlap each of the pixel defining layer PDL and the spacer SPC in a plan view. The transmission pattern TP may serve to maintain a space SP between the first substrate SUB1 and the second substrate SUB2 together with the spacer SPC.

The transmission pattern TP may transmit light. The transmission pattern TP may transmit incident light L1 incident from outside through the second substrate SUB2. In addition, the transmission pattern TP may transmit light L4 emitted from the light emitting element LD to the outside. In an embodiment, the transmission pattern TP may include a transparent organic material.

The light blocking pattern BP may be disposed on the transmission pattern TP. In an embodiment, the light blocking pattern BP may define an opening OP that accommodates at least a portion of the spacer SPC. The light blocking pattern BP may cover at least a portion of a side surface of the spacer SPC accommodated in the opening OP. That is, at least a portion of each of the spacer SPC, the common electrode CE disposed on the spacer SPC, and the capping layer CPL disposed on the spacer SPC may fill the opening OP. In addition, the opening OP may expose at least a portion of the transmission pattern TP. The transmission pattern TP and the capping layer CPL may be in contact with each other in the opening OP.

The light blocking pattern BP may include a light blocking material. In an embodiment, for example, the light blocking pattern BP may include a black matrix. The light blocking pattern BP may absorb or block the incident light L1 incident from the outside through the second substrate SUB2 and the reflected light L2 which is the incident light L1 is reflected by the pixel defining layer PDL.

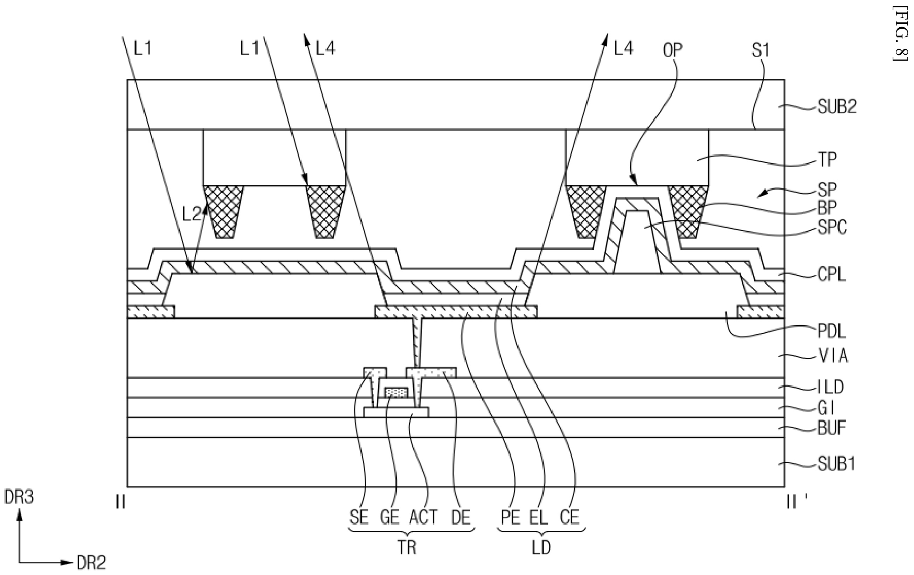

FIG. 8 is a cross-sectional view illustrating another example of FIG. 7.

Referring to FIGS. 6 and 8, the display device 20 may include the first substrate SUB1, the buffer layer BUF, the transistor TR, the gate insulating layer GI, the interlayer-insulating layer ILD, the via-insulating layer VIA, the pixel defining layer PDL, the light emitting element LD, the spacer SPC, the capping layer CPL, the transmission pattern TP, the light blocking pattern BP, and the second substrate SUB2.

However, the display device 20 described with reference to FIG. 8 may be substantially the same as or similar to the display device 20 described with reference to FIG. 7, except for the spacer SPC. Hereinafter, redundant descriptions will be omitted or simplified.

The buffer layer BUF, the active pattern ACT, the gate insulating layer GI, the gate electrode GE, the interlayer-insulating layer ILD, the source electrode SE, the drain electrode DE, the via-insulating layer VIA, the pixel electrode PE, the pixel defining layer PDL, and the light emitting layer EL may be sequentially disposed on the first substrate SUB1.

The spacer SPC may be disposed on the pixel defining layer PDL. In an embodiment, the spacer SPC may be disposed on some of the pixel defining layers PDL. That is, the spacer SPC may overlap some of the pixel defining layers PDL, and may not overlap others of the pixel defining layers PDL in a plan view.

The common electrode CE may be disposed on the light emitting layer EL, the pixel defining layer PDL, and the spacer SPC, and the capping layer CPL may be disposed on the common electrode CE.

The transmission pattern TP may be disposed between the capping layer CPL and the second substrate SUB2. Specifically, the transmission pattern TP may be disposed on the surface S1 of the second substrate SUB2 facing the first substrate SUB1.

In an embodiment, some of the transmission patterns TP may overlap each of the pixel defining layer PDL and the spacer SPC in a plan view. Others of the transmission patterns TP may overlap the pixel defining layer PDL, and may not overlap the spacer SPC in a plan view. That is, the spacer SPC may overlap at least one of the transmission patterns TP.

In other words, some of the transmission patterns TP may contact each of the surface S1 of the second substrate SUB2 and the capping layer CPL. Others of the transmission patterns TP may contact the surface S1 of the second substrate SUB2, and may not contact the capping layer CPL.

The light blocking pattern BP may be disposed on the transmission pattern TP. The light blocking pattern BP may define the opening OP that accommodates at least a portion of the spacer SPC. That is, the opening OP of the light blocking pattern BP may accommodate at least a portion of the spacer SPC overlapping the transmission pattern TP in a plan view. In other words, the spacer SPC may be accommodated in the opening OP of at least one of the light blocking patterns BP. The light blocking pattern BP may cover at least a portion of a side surface of the spacer SPC accommodated in the opening OP.

In addition, the opening OP of the light blocking pattern BP may expose at least a portion of the transmission pattern TP. When the transmission pattern TP and the spacer SPC overlap each other in a plan view, the transmission pattern TP and the capping layer CPL may be in contact with each other in the opening OP.

In the display device 20 according to an embodiment of the present invention, the transmission pattern TP and the light blocking pattern BP overlapping the pixel defining layer PDL in a plan view may be disposed on the second substrate SUB2. As the transmission pattern TP transmits the light L4 emitted from the light emitting element LD, a viewing angle may be secured when the light emitting element LD emits light. In addition, as the light blocking pattern BP blocks the incident light L1 and the reflected light L2, the rainbow-colored color shift phenomenon visually recognized at the side viewing angle may be effectively improved.

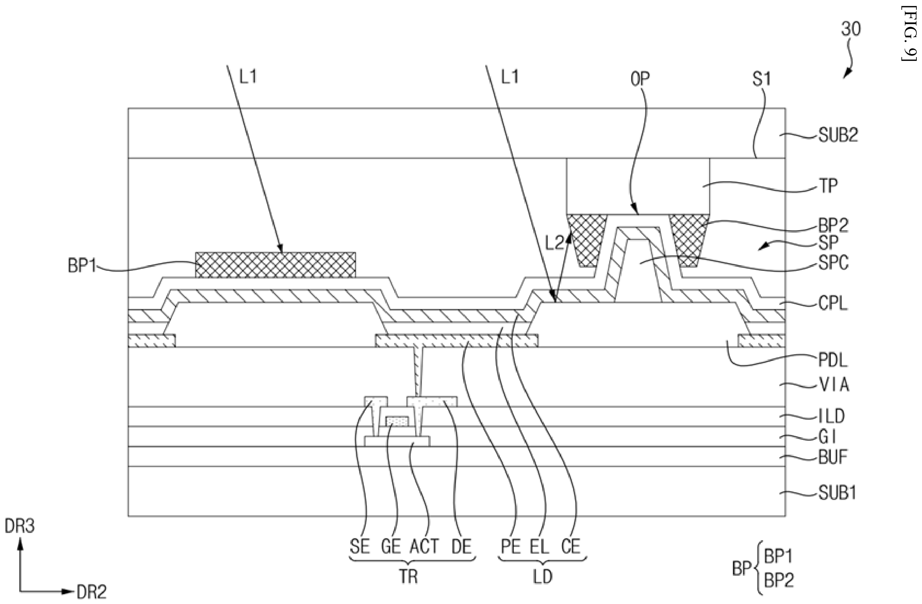

FIG. 9 is a cross-sectional view illustrating a display device according to still another embodiment of the present invention. For example, FIG. 9 may correspond to the cross-sectional view of FIG. 7.

Hereinafter, descriptions overlapping the display device 10 described with reference to FIGS. 1, 2, 3, 4 and 5 will be omitted or simplified.

Referring to FIG. 9, a display device 30 may include a first substrate SUB1, a buffer layer BUF, a transistor TR, a gate insulating layer GI, an interlayer-insulating layer ILD, a via-insulating layer VIA, a pixel defining layer PDL, a spacer SPC, a light emitting element LD, a capping layer CPL, a transmission pattern TP, a light blocking pattern BP, and a second substrate SUB2.

The transistor TR may include an active pattern ACT, a gate electrode GE, a source electrode SE, and a drain electrode DE. The light emitting element LD may include a pixel electrode PE, a light emitting layer EL, and a common electrode CE.

The transmission pattern TP may be disposed between the capping layer CPL and a surface S1 of the second substrate SUB2 facing the first substrate SUB1. In an embodiment, the transmission pattern TP may overlap each of the pixel defining layer PDL and the spacer SPC in a plan view.

The light blocking pattern BP may be disposed on the capping layer CPL. The light blocking pattern BP may overlap the pixel defining layer PDL in a plan view. The light blocking pattern BP may include a first light blocking pattern BP1 and a second light blocking pattern BP2.

The first light blocking pattern BP1 may overlap the pixel defining layer PDL, and may not overlap the spacer SPC in a plan view.

The second light blocking pattern BP2 may be disposed on the transmission pattern TP. The second light blocking pattern BP2 may overlap each of the pixel defining layer PDL and the spacer SPC in a plan view. The second light blocking pattern BP2 may define an opening OP that accommodates at least a portion of the spacer SPC and exposes at least a portion of the transmission pattern TP. The second light blocking pattern BP2 may cover at least a portion of a side surface of the spacer SPC accommodated in the opening OP.

The light blocking pattern BP may include an organic light blocking material or an inorganic light blocking material. The light blocking pattern BP may absorb or block incident light L1 incident from outside through the second substrate SUB2. In addition, the light blocking pattern BP may absorb or block reflected light L2 in which the incident light L1 is reflected by the pixel defining layer PDL.

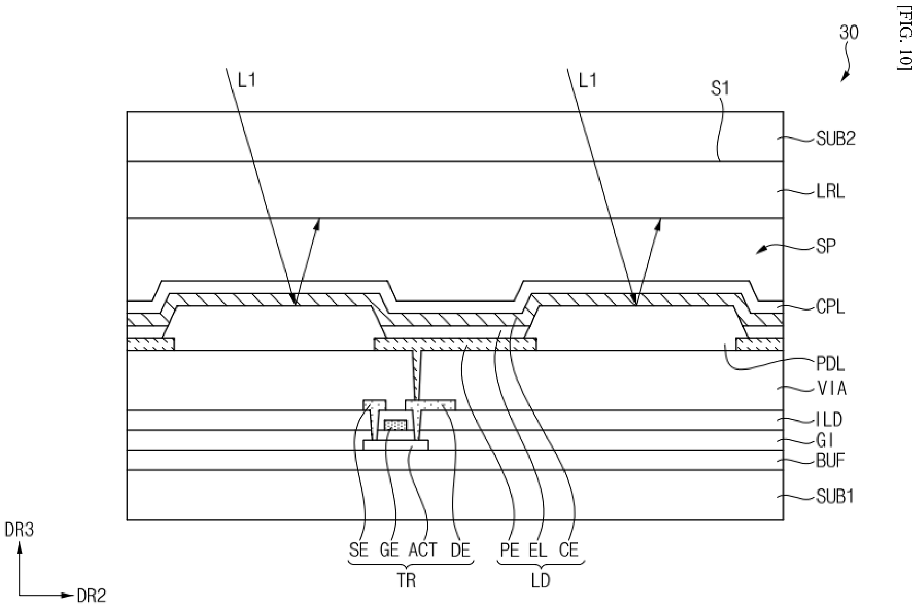

FIG. 10 is a cross-sectional view illustrating another example of FIG. 9.

Referring to FIG. 10, the display device 30 may include the first substrate SUB1, the buffer layer BUF, the transistor TR, the gate insulating layer GI, the interlayer-insulating layer ILD, the via-insulating layer VIA, the pixel defining layer PDL, the light emitting element LD, the capping layer CPL, a low reflection layer LRL, and the second substrate SUB2.

However, the display device 30 described with reference to FIG. 10 may be substantially the same as or similar to the display device 30 described with reference to FIG. 9, except for the low reflection layer LRL. Hereinafter, redundant descriptions will be omitted or simplified.

In an embodiment, the low reflection layer LRL may be disposed between the capping layer CPL and the second substrate SUB2. Specifically, the low reflection layer LRL may be disposed on the surface S1 of the second substrate SUB2 facing the first substrate SUB1. In an embodiment, for example, the low reflection layer LRL may have a multilayer structure in which a plurality of layers are stacked. The low reflection layer LRL may reduce a reflectance of the incident light L1 incident from the outside.

In the display device 30 according to an embodiment of the present invention, at least one of the light blocking pattern BP and the low reflection layer LRL may be disposed between the first substrate SUB1 and the second substrate SUB2. Accordingly, a rainbow-colored color shift phenomenon visually recognized at the side viewing angle may be effectively improved.

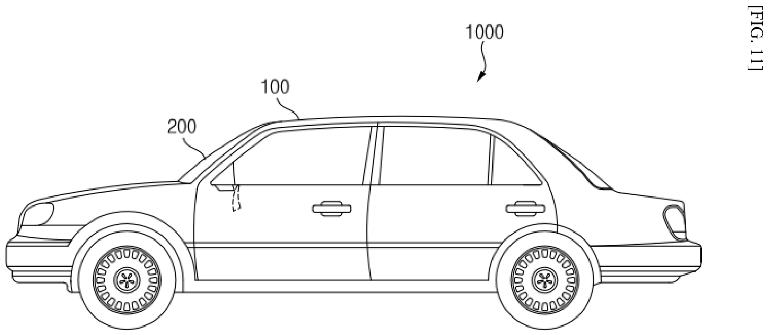

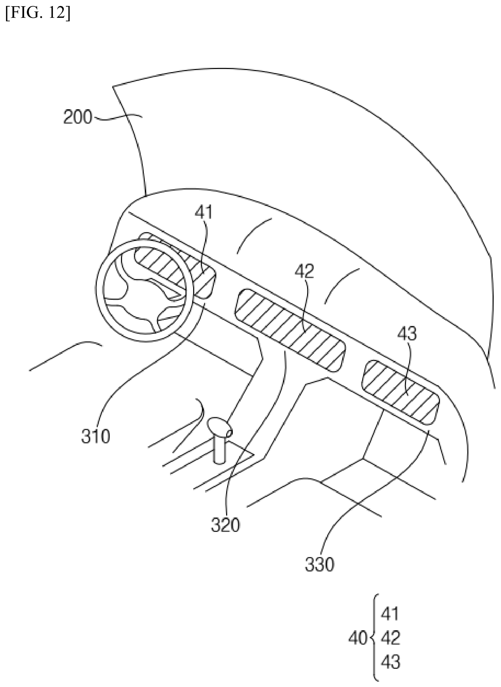

FIG. 11 is a view schematically illustrating an exterior of a vehicle according to an embodiment of the present invention. FIG. 12 is a view schematically illustrating an interior space of the vehicle of FIG. 11.

Referring to FIGS. 11 and 12, a vehicle 1000 may be a device that moves a transport object such as a human, an object, an animal, or the like from a departure point to a destination. In an embodiment, for example, the vehicle 1000 may include a three-wheel or four-wheel vehicle, a construction machine, a two-wheel vehicle, a motor device, a bicycle, a train that drives on a track, a ship that drives on a sea or river, or the like.

The vehicle 1000 may include a vehicle body 100 and a chassis.

The vehicle body 100 may form an exterior of the vehicle 1000, and may define an interior space in which a driver and a passenger board. In an embodiment, for example, the vehicle body 100 may include a front window glass 200, a bonnet, a roof panel, a rear panel, a trunk, or the like. The chassis may include a mechanical device for driving. In an embodiment, for example, the chassis may include a power generator, a power transmission device, a driving device, a steering device, a braking device, a suspension device, a transmission device, a fuel device, or the like.

The vehicle 1000 may include a cluster 310, a center fascia 320, a passenger seat dashboard 330, and a display device 40.

The cluster 310 may be located in front of a steering wheel. A tachometer, a speedometer, a coolant thermometer, a fuel gauge, a direction change indicator light, a high beam indicator light, a warning light, a seat belt warning light, an odometer, an automatic shift selection lever indicator light, a door open warning light, an engine oil warning light, a fuel shortage warning light, or the like may be disposed on the cluster 310.

The center fascia 320 may be adjacent to a side of the cluster 310. An audio device, an air conditioner, a control panel with a plurality of buttons for adjusting a heater of a seat, or the like may be disposed on the center fascia 320.

The passenger seat dashboard 330 may be adjacent to a side of the center fascia 320. That is, the passenger dashboard 330 may be spaced apart from the cluster 310 with the center fascia 320 interposed therebetween. In an embodiment, the cluster 310 may be disposed corresponding to a driver's seat, and the passenger seat dashboard 330 may be disposed corresponding to a passenger's seat.

The display device 40 may be disposed in the interior space. The display device 40 may correspond to the display devices 10, 20, and 30 described with reference to FIGS. 1 to 10. That is, the display device 40 may have a structure substantially the same as or similar to the display devices 10, 20, and 30 described with reference to FIGS. 1 to 10.

The display device 40 may be disposed on at least one of the cluster 310, the center fascia 320, and the passenger seat dashboard 330. In other words, the display device 40 may include at least one of a first display device 41 disposed on the cluster 310, a second display device 42 disposed on the center fascia 320, and a third display device 43 disposed on the passenger seat dashboard 330. However, the present invention is not limited thereto, and an arrangement of the display device 40 may be variously changed. Alternatively, the display device 40 may be disposed on other configurations of the vehicle 1000, such as a front window glass 200, a room mirror, or the like.

In an embodiment, for example, the first display device 41 may be disposed on the cluster 310 to provide vehicle information, speed information, or the like to the driver. The second display device 42 may be disposed on the center fascia 320 to provide map information, vehicle setting information, or the like. The third display device 43 may be disposed on the passenger seat dashboard 330 to provide entertainment information, or the like to the passenger. However, the present invention is not limited thereto, and information provided by the first, second, and third display devices 41, 42, and 43 may be variously changed.

In an embodiment, the first, second, and third display devices 41, 42, and 43 may minimize light traveling toward the front window glass 200 so as not to interfere with the driver's front driving vision. In addition, at least one of the first, second, and third display devices 41, 42, and 43 may be switched between a wide viewing angle mode and a narrow viewing angle mode.

In FIG. 12, the first, second, and third display devices 41, 42, and 43 are illustrated to be spaced apart from each other, but the present invention is not limited thereto. Alternatively, the first, second, and third display devices 41, 42, and 43 may be connected to each other in another embodiment.

[Industrial Applicability]

The present invention can be applied to display devices and vehicles including the same. For example, the present invention can be applied to high-resolution smartphones, mobile phones, smart pads, smart watches, tablet PCs, vehicle navigation systems, televisions, computer monitors, laptops, or the like.

Although a few embodiments of the present invention have been described, those skilled in the art will readily appreciate that various modifications are possible to the present invention without materially departing from the novel teachings and advantages of the present inventive concept.

[Description of Legend]

    10, 20, 30, 40: display device
    SUB1: first substrate
    SUB2: second substrate
    PE: pixel electrode
    PDL: pixel defining layer
    SPC: spacer
    SP: space
    BP: light blocking pattern
    TP: transmission pattern
    OP: opening
    SM: sealing member
    1000: vehicle
    310: cluster
    320: center fascia
    330: passenger seat dashboard

**Claims**

1. A display device comprising:

    a first substrate;

a pixel electrode disposed on the first substrate;

a pixel defining layer disposed on the first substrate and covering at least a portion of the pixel electrode;

a second substrate disposed on the pixel defining layer and spaced apart from the first substrate and the pixel defining layer to define a space between the second substrate and the pixel defining layer; and

a light blocking pattern disposed on a surface of the second substrate facing the first substrate and overlapping the pixel defining layer in a plan view.

2. The display device of claim 1, wherein a distance between an edge of a surface of the pixel defining layer facing the second substrate and an edge of a surface of the light blocking pattern facing the second substrate satisfies following Equation 1:

$$X = D \times \tan\left[\sin^{-1}\left\{\frac{n2}{n1} \times \sin\left(\sin^{-1}\left(\frac{n3}{n2} \times \sin\Theta\right)\right)\right\}\right] \pm 1 \text{ micrometers (μm)},$$

wherein X is the distance between the edge of the surface of the pixel defining layer and the edge of the surface of the light blocking pattern, D is a distance between the surface of the pixel defining layer and the surface of the second substrate, n1 is a refractive index of the space, n2 is a refractive index of the second substrate, n3 is a refractive index of air, and θ is a viewing angle.

3. The display device of claim 2, wherein a width of the surface of the light blocking pattern satisfies following Equation 2:

$$W = G - 2X,$$

wherein W is the width of the surface of the light blocking pattern, and G is a width of the surface of the pixel defining layer.

4. The display device of claim 1, further comprising:
a spacer disposed between the pixel defining layer and the light blocking pattern.

5. The display device of claim 4, wherein a sum of a thickness of the light blocking pattern and a thickness of the spacer is greater than about 3 micrometers (μm) and less than or equal to about 20 μm.

6. The display device of claim 4, wherein the light blocking pattern is provided in plurality, and the spacer overlaps at least one of the plurality of light blocking patterns in the plan view.

7. The display device of claim 4, wherein a maximum width of the light blocking pattern is greater than a width of the spacer.

8. The display device of claim 4, further comprising:

a light emitting layer disposed on the pixel electrode;

a common electrode disposed on the light emitting layer, the pixel defining layer, and the spacer; and

a capping layer disposed on the common electrode.

9. The display device of claim 1, wherein the light blocking pattern includes a black matrix.

10. The display device of claim 1, further comprising:
a sealing member disposed between the first substrate and the second substrate along an edge of each of the first substrate and the second substrate and coupling the first substrate and the second substrate.

11. The display device of claim 1, wherein the second substrate includes a glass substrate.

12. The display device of claim 1, wherein the space is an empty space.

13. The display device of claim 1, wherein the space is filled with a filler.

14. A vehicle comprising:

13

a vehicle body defining an interior space; and
a display device disposed in the interior space,
wherein the display device includes:

a first substrate;
a pixel electrode disposed on the first substrate;
a pixel defining layer disposed on the first substrate and covering at least a portion of the pixel electrode;
a spacer disposed on the pixel defining layer;
a second substrate disposed on the spacer and spaced apart from the first substrate and the spacer to define a space between the second substrate and pixel defining layer;
a transmission pattern disposed on a surface of the second substrate facing the first substrate and overlapping the pixel defining layer in a plan view; and
a light blocking pattern disposed on the transmission pattern and defining an opening, which accommodates at least a portion of the spacer.

15. The vehicle of claim 14, wherein the light blocking pattern covers at least a portion of a side surface of the spacer.

16. The vehicle of claim 14, wherein the light blocking pattern is provided in plurality, and the spacer is accommodated in the opening of at least one of the plurality of light blocking patterns.

17. The vehicle of claim 14, wherein the transmission pattern includes a transparent organic material.

18. The vehicle of claim 14, wherein the light blocking pattern includes a black matrix.

19. The vehicle of claim 14, wherein the display device further includes:
a sealing member disposed between the first substrate and the second substrate along an edge of each of the first substrate and the second substrate and coupling the first substrate and the second substrate.

20. The vehicle of claim 14, wherein the second substrate includes a glass substrate.

21. The vehicle of claim 14, wherein the space is in an empty space.

22. The vehicle of claim 14, wherein the space is filled with a filler.

23. The vehicle of claim 14, further comprising:

a cluster;
a center fascia adjacent to the cluster; and
a passenger seat dashboard adjacent to the center fascia,
wherein the display device is disposed on at least one of the cluster, the center fascia, and the passenger seat dashboard.

[FIG. 1]

10

PX ...
:

NDA
DA

I

I'

DR2

DR1

[FIG. 2]

[FIG. 3]

[FIG. 4]

EP 4 730 975 A1

[FIG. 5]

[FIG. 6]

[FIG. 7]

EP 4 730 975 A1

L1

L1

L4

L4

OP

S1

SUB2

TP

SP
BP
SPC

L2

CPL

PDL

VIA

ILD

GI

BUF

SUB1

II

II'

SE GE ACT DE
TR

PE EL CE
LD

DR3

DR2

[FIG. 8]

SUB2, TP, SP, BP, SPC, CPL, PDL, VIA, ILD, GI, BUF, SUB1

S1, OP, L4, L1, L2

II', II

CE, EL, PE — LD

DE, ACT, GE, SE — TR

DR2, DR3

[FIG. 9]

EP 4 730 975 A1

30

SUB2

TP

BP2
SP
SPC

CPL

PDL

VIA

ILD

GI

BUF

SUB1

L1

L1

OP

S1

BP1

L2

SE GE ACT DE
TR

PE EL CE
LD

BP { BP1
     BP2

DR3

DR2

23

[FIG. 10]

[FIG. 11]

[FIG. 12]

## INTERNATIONAL SEARCH REPORT

| International application No. |
|---|
| **PCT/KR2024/008134** |

| A. | CLASSIFICATION OF SUBJECT MATTER |
|---|---|

**H10K 59/80**(2023.01)i; **H10K 59/122**(2023.01)i; **B60K 35/00**(2006.01)i; **B60K 35/60**(2024.01)i; **B60K 35/22**(2024.01)i; **B60K 35/40**(2024.01)i; **H10K 102/00**(2023.01)i

According to International Patent Classification (IPC) or to both national classification and IPC

| B. | FIELDS SEARCHED |
|---|---|

Minimum documentation searched (classification system followed by classification symbols)

H10K 59/80(2023.01); G02B 5/20(2006.01); H01L 27/32(2006.01); H01L 51/50(2006.01); H01L 51/52(2006.01); H05B 33/10(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 표시 장치(display), 화소 정의막(pixel defining layer), 차광 패턴(light shield pattern), 스페이서(spacer), 블랙 매트릭스(black matrix), 투과 패턴(light transmitting pattern), 개구(opening), 차량(vehicle)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | KR 10-2459916 B1 (LG DISPLAY CO., LTD.) 26 October 2022 (2022-10-26)<br>See paragraphs [0023]-[0089]; claim 1; and figures 1-5. | 1-3,9-13 |
| Y | | 4-8 |
| A | | 14-23 |
| Y | KR 10-2090709 B1 (SAMSUNG DISPLAY CO., LTD.) 19 March 2020 (2020-03-19)<br>See paragraphs [0052]-[0057]; claim 19; and figures 1-2. | 4-8 |
| A | CN 112002821 A (SHENZHEN CHINA STAR OPTOELECTRONICS SEMICONDUCTOR DISPLAY TECHNOLOGY CO., LTD.) 27 November 2020 (2020-11-27)<br>See paragraphs [0032]-[0075]; and figures 1-5. | 1-23 |
| A | KR 10-1957145 B1 (LG DISPLAY CO., LTD.) 13 March 2019 (2019-03-13)<br>See paragraphs [0023]-[0068]; and figures 1-3. | 1-23 |

☑ Further documents are listed in the continuation of Box C.　　☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **23 September 2024** | **23 September 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
|---|
| **PCT/KR2024/008134** |

**C.    DOCUMENTS CONSIDERED TO BE RELEVANT**

| Category* | Citation of document, with indication, where appropriate, of the relevant passages | Relevant to claim No. |
|---|---|---|
| A | KR 10-2016-0015525 A (SAMSUNG DISPLAY CO., LTD.) 15 February 2016 (2016-02-15) <br> See paragraphs [0023]-[0080]; and figures 1-4. | 1-23 |

Form PCT/ISA/210 (second sheet) (July 2022)

**INTERNATIONAL SEARCH REPORT**
Information on patent family members

International application No.

**PCT/KR2024/008134**

| Patent document cited in search report | | | Publication date (day/month/year) | Patent family member(s) | | | Publication date (day/month/year) |
|---|---|---|---|---|---|---|---|
| KR | 10-2459916 | B1 | 26 October 2022 | KR | 10-2017-0067361 | A | 16 June 2017 |
| | | | | KR | 10-2022-0147567 | A | 03 November 2022 |
| KR | 10-2090709 | B1 | 19 March 2020 | CN | 104218183 | A | 17 December 2014 |
| | | | | CN | 104218183 | B | 05 December 2017 |
| | | | | KR | 10-2014-0141372 | A | 10 December 2014 |
| | | | | TW | 201507143 | A | 16 February 2015 |
| | | | | US | 2014-0353630 | A1 | 04 December 2014 |
| | | | | US | 2016-0322438 | A1 | 03 November 2016 |
| | | | | US | 9419242 | B2 | 16 August 2016 |
| | | | | US | 9548342 | B2 | 17 January 2017 |
| CN | 112002821 | A | 27 November 2020 | CN | 112002283 | A | 27 November 2020 |
| | | | | CN | 112002821 | B | 08 March 2022 |
| | | | | US | 2022-0045306 | A1 | 10 February 2022 |
| | | | | US | 2022-0319414 | A1 | 06 October 2022 |
| | | | | WO | 2022-027743 | A1 | 10 February 2022 |
| | | | | WO | 2022-027771 | A1 | 10 February 2022 |
| KR | 10-1957145 | B1 | 13 March 2019 | KR | 10-2014-0083143 | A | 04 July 2014 |
| KR | 10-2016-0015525 | A | 15 February 2016 | KR | 10-2239842 | B1 | 14 April 2021 |
| | | | | US | 2016-0035795 | A1 | 04 February 2016 |
| | | | | US | 9627452 | B2 | 18 April 2017 |

Form PCT/ISA/210 (patent family annex) (July 2022)